(19) Europäisches Patentamt
European Patent Office
Office européen des brevets

(11) **EP 2 926 388 B1**

(12) **FASCICULE DE BREVET EUROPEEN**

(45) Date de publication et mention
de la délivrance du brevet:
**30.05.2018 Bulletin 2018/22**

(21) Numéro de dépôt: **13796088.6**

(22) Date de dépôt: **28.11.2013**

(51) Int Cl.:
*H01L 51/52* (2006.01)    *H01L 51/50* (2006.01)
*B32B 17/10* (2006.01)

(86) Numéro de dépôt international:
**PCT/EP2013/074976**

(87) Numéro de publication internationale:
**WO 2014/083110 (05.06.2014 Gazette 2014/23)**

(54) **DISPOSITIF ORGANIQUE ÉLECTRONIQUE OU OPTOÉLECTRONIQUE LAMINÉ**

LAMINIERTE ORGANISCHE ELEKTRONISCHE ODER OPTOELEKTRONISCHE VORRICHTUNG

LAMINATED ORGANIC ELECTRONIC OR OPTOELECTRONIC DEVICE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **29.11.2012 BE 201200810**

(43) Date de publication de la demande:
**07.10.2015 Bulletin 2015/41**

(73) Titulaire: **AGC Glass Europe
1348 Louvain-La-Neuve (BE)**

(72) Inventeurs:
• **DOMERCQ, Benoit
B-1420 Braine-L'Alleud (BE)**
• **NOVOTNY, Marek
B-6534 Gozée (BE)**
• **LINTHOUT, Sébastien
B-1390 Archennes (BE)**
• **VIVIER, Jonathan
B-5030 Beuzet (BE)**
• **VIGNERI, Nunzio
B-7100 Saint-Vaast (BE)**

(74) Mandataire: **Agustsson, Sveinn Otto et al
AGC Glass Europe S.A.
Rue Louis Blériot, 12
6041 Gosselies (BE)**

(56) Documents cités:
**EP-A2- 1 079 666       WO-A2-2008/012460
DE-A1-102007 039 416   JP-A- H08 236 271
JP-A- 2006 228 519     JP-A- 2013 110 262
US-A1- 2010 148 665**

• **Levapren: "DURABILITY ENERGIZED BY
Lanxess", , 1 décembre 2013 (2013-12-01), pages
1-24, XP055102830, Extrait de l'Internet:
URL:http://levapren.com/uploads/tx_lxsmatr
ix/Levapren_Broschure.pdf [extrait le
2014-02-18]**
• **"Hole Transport Layer Materials (HTL)", , 16 juillet
2011 (2011-07-16), XP055102874, Extrait de
l'Internet:
URL:http://www.ohjec.com/el/pdf/el-2-1.pdf
[extrait le 2014-02-18]**

## Description

Le domaine de l'invention est celui des dispositifs organiques électroniques connus sous l'acronyme OTFT (Organic Thin-Film Transistor) ou des dispositifs organiques optoélectroniques tel que les cellules photovoltaïques organiques, également appelées OPV de l'anglais Organic Photovoltaics, ou les dispositifs organiques électroluminescents désignés sous l'appellation OLED de l'anglais <u>O</u>rganic <u>L</u>ight-<u>E</u>mitting Device, ou encore les dispositifs à encre électrophorétique ou "papier électronique"

Plus précisément, l'invention concerne des dispositifs organiques électroniques ou optoélectroniques intégrés par assemblage dans des structures verrières. Plus particulièrement, le domaine de l'invention est celui des dispositifs organiques électroluminescents intégrés par assemblage dans des structures verrières. Par le terme « assemblage », on entend désigner un procédé nécessitant d'une part la compression des éléments, substrats et film intercalaire notamment, constituant la structure verrière, et d'autre part, l'utilisation de températures élevées, ces conditions étant nécessaires à l'obtention d'une forte adhérence entre le film intercalaire et les deux substrats entre lesquels ledit film intercalaire est emprisonné.

Un dispositif organique électronique (OTFT) ou optoélectronique (OPV, OLED) se présente sous la forme d'un premier support sur lequel sont déposés successivement :

- une première électrode,
- un empilement de couches organiques semi-conductrices permettant soit l'émission de lumière (OLED), soit la génération de charges électriques (OPV), soit le transport de charges électriques (OLED, OPV, OTFT)
- une seconde électrode,
- et un second support couvercle ou support d'encapsulation tel qu'un revêtement protecteur contre l'humidité et l'oxygène par exemple.

Dans le cas d'un dispositif organique électroluminescent l'empilement de couches organiques semi-conductrices comprend plus particulièrement une couche électroluminescente avec de part et d'autre de celle-ci, des couches organiques additionnelles qui facilitent le transport des charges, parmi lesquelles une couche de transport de trous et une couche transportant des électrons.

Les problèmes majeurs liés aux dispositifs organiques électroniques ou optoélectroniques sont d'une part l'extrême sensibilité à l'humidité et à l'oxygène des matériaux organiques constituant les couches semi-conductrices et d'autre part la très grande fragilité mécanique de ces dispositifs. De ce fait, ces dispositifs doivent être protégés physiquement contre toute dégradation mécanique et isolés de toute contamination extérieure ; ceci est généralement réalisé par confinement. Un tel confinement peut être réalisé lorsque le dispositif organique électronique ou optoélectronique est emprisonné entre deux substrats imperméables. Les substrats imperméables sont habituellement choisis parmi le verre, l'acier ou des plastiques recouverts d'une couche barrière en matériau inorganique. Généralement, au moins un des substrats, parfois les deux sont en verre.

Classiquement, l'assemblage de deux substrats imperméables dont au moins un des substrats, parfois les deux, est en verre requiert l'utilisation d'un film adhésif intercalaire généralement choisi parmi un polyvinyle de butyral (PVB) ou un copolymère éthylène/acétate de vinyle (EVA). Un cycle classique d'assemblage tel que celui pratiqué en autoclave nécessite l'utilisation de températures élevées et de pressions nécessaires à l'obtention d'une forte adhérence entre le film adhésif intercalaire et les deux substrats entre lesquels ledit film adhésif intercalaire est emprisonné. Lorsque les deux substrats sont en verre, la structure verrière obtenue est appelée « verre feuilleté ».

Toutefois, un obstacle majeur à l'incorporation de dispositifs organiques électroniques ou optoélectroniques au sein d'un assemblage de deux substrats imperméables réside dans la dégradation des propriétés des matériaux constituant la partie organique desdits dispositifs lorsque ces derniers sont soumis à une température élevée. De ce fait, un soin particulier doit être apporté lors de l'assemblage de la structure comprenant les dispositifs organiques électroniques ou optoélectroniques car il faut tenir compte d'une part des températures requises pour obtenir une adhérence entre les substrats laminés et d'autre part éviter une détérioration importante des propriétés des matériaux organiques constituants lesdits dispositifs.

De ce fait, il est indispensable que de nouvelles structures comprenant des dispositifs organiques électroniques ou optoélectroniques soient développées dans le but d'augmenter le temps de vie de ces dispositifs, ces structures étant obtenues par assemblage de substrats imperméables.

Le document BRMU8802233(U2) décrit de manière très succincte une structure constituée d'OLEDs confinées entre des substrats en verre sans toutefois divulguer de manière spécifique la nature des composés organiques utilisés dans lesdits dispositifs organiques électroluminescents. En outre, aucun procédé mis en oeuvre pour fabriquer une telle structure n'est décrit.

Le document JP08236271 décrit un dispositif organique électroluminescent comprenant une couche d'encapsulation en résine ayant une température de transition vitreuse de -60°C.

Le document JP2006228519 décrit un dispositif OLED encapsulé dans lequel un adhésif ayant une température de transition vitreuse de -35°C est utilisé.

Le document US20100148665 décrit l'encapsulation de dispositifs optoélectroniques insérés entre deux supports par l'intermédiaire de couches barrières et d'adhésifs. Des moyens de connexion sont également décrits. Le document WO2008/012460 décrit un dispositif électroluminescent encapsulé ayant pour objectif de fournir un système de connexion électrique simplifié. L'invention porte sur un "entourage", sur le pourtour du dispositif, servant pour au moins une connexion électrique. Les moyens d'assemblage décrits dans ce document sont nombreux et variés. WO2008/012460 enseigne l'importance de choisir un assemblage étanche, mais qui adhère également très bien aux matériaux avec qui il est en contact. Dans une configuration décrite, le moyen pour solidariser capot et substrat est un intercalaire de feuilletage, mais aucun enseignement particulier n'est donné quant à son choix ou les propriétés qu'il devrait avoir. Or, en tentant de reproduire des assemblages tels que décrit dans WO2008/012460, nous avons observé des pertes de continuité, des problèmes de diffusion, et donc un mauvais fonctionnement des dispositifs réalisés. De plus, l'aspect esthétique des assemblages n'était pas de qualité, donnant par exemple des effets "peau de léopard".

L'invention a notamment pour objectif de pallier ces inconvénients de l'art antérieur. Plus précisément, un objectif de l'invention, dans au moins un de ses modes de réalisation, est de fournir un verre feuilleté comprenant un dispositif organique électronique ou optoélectronique, préférentiellement un dispositif organique électroluminescent. L'invention concerne une structure telle que décrite dans la revendication 1. Selon l'invention, une telle structure est telle que l'empilement de couches organiques semi-conductrices consiste en, c'est-à-dire contient exclusivement, des matériaux dont la température de transition vitreuse ($Tg_M$) est telle que :

$$Tg_M \ - \ Tg_f \ \geq \ 150^{\circ}C,$$

préférentiellement $\geq$ 160°C, avec $Tg_f$ : température de transition vitreuse du matériau constituant le au moins un film adhésif intercalaire, préférentiellement le seul film adhésif intercalaire.

Le principe général de l'invention repose sur une sélection des matériaux de l'empilement des couches organiques semi-conductrices en fonction de la nature du matériau constituant le au moins un film intercalaire, préférentiellement le seul film intercalaire. Les inventeurs ont déterminé que de manière surprenante une telle sélection pouvait être réalisée sur base des températures de transition vitreuse des différents matériaux constituant les couches organiques semi-conductrices ainsi que le au moins un film intercalaire.

Ainsi, l'invention repose sur une approche tout à fait nouvelle et inventive car elle fournit un mode de sélection des différents matériaux constituant le dispositif organique électronique ou optoélectronique, plus particulièrement le dispositif organique électroluminescent, plus particulièrement lorsque ladite structure est obtenue par assemblage requérant des températures supérieures à 110°C.

Avantageusement, la structure selon l'invention est telle que le au moins un film adhésif intercalaire, préférentiellement le seul film intercalaire, est constitué d'une ou plusieurs couches de matières plastiques, ces couches étant de même nature, choisies dans le groupe constitué des polyvinyle de butyral (PVB), des polyuréthanes, notamment des polyuréthanes thermoplastiques ou des polyuréthanes RIM, des polycarbonates, des polyméthacrylates de méthyle, des polypropylènes, des copolymères éthylène/acétate de vinyle, des copolymères cyclooléfiniques, des polyéthylènes notamment sous forme de résines ionomères telles que des copolymères d'acide (meth) acrylique et d'éthylène, neutralisés par une polyamine, des polyesters thermoplastique, notamment des poly (téréphtalates d'éthylène) ou des polyesters thermodurcissables insaturés, des résines acryliques éventuellement modifiées et des copolymères chlorure de vinyle/méthacrylate de glycidyl ; préférentiellement choisies dans le groupe constitués des polyvinyles de butyral (PVB) et des copolymères éthylène/acétate de vinyle (EVA) ; le plus préférentiellement des copolymères éthylène/acétate de vinyle (EVA). L'EVA est préféré car il nécessite des temps de procédé d'assemblage plus courts et de plus faibles températures de mise en oeuvre.

Selon un mode de réalisation préférentiel ou conforme à l'invention, la structure selon l'invention est une structure assemblée dont les matériaux constituant l'empilement de couches organiques ont une température de transition vitreuse ($Tg_M$) supérieure ou égale à la température maximum requise lors du procédé d'assemblage ($T_a$). Les inventeurs ont déterminé que de manière surprenante, le respect d'une telle condition permet de réduire la détérioration des propriétés électroniques et/ou électrooptiques. Par « détérioration des propriétés électroniques », on entend désigner, dans le cas d'un OTFT (Organic Thin-Film Transistor), une diminution de la mobilité de charge ou de la tension d'opération minimale mesurée par une source de courant-tension (ampèremètre et/ou voltmètre). Par détérioration des propriétés électrooptiques, on entend désigner, dans le cas d'une OLED, une diminution de la quantité de lumière émise par un dispositif organique électroluminescent de 10 à 20% mesurée par un spectrophotomètre ou, dans le cas d'une cellule photovoltaïque, une diminution de la quantité d'électricité produite de 20%, préférentiellement de 10%, mesurée par la différence entre la puissance maximale produite avant assemblage et après assemblage.

Selon un mode de réalisation préféré du mode précédent, la structure est telle que la température de transition vitreuse ($Tg_M$) des matériaux constituant l'empilement de couches organiques est supérieure ou égale à 130°C. Les inventeurs ayant observé que de manière surprenante les matériaux présentant de tels températures de transition vitreuse sont aptes à être utilisés lors d'un processus d'assemblage nécessitant des tempéra-

tures ($T_a$) supérieures à 110°C, voire 120°C.

Selon l'invention, la structure selon l'invention est telle qu'au moins un des deux substrats imperméables est un substrat verrier. L'avantage lié à l'utilisation d'un substrat verrier réside dans la combinaison des propriétés de transparence et d'imperméabilité de ce dernier. Préférentiellement, le substrat verrier est choisi parmi les verres minéraux ou organiques. Les verres minéraux sont préférés. Parmi ceux-ci, on préfère les verres silicosodocalciques clairs ou colorés dans la masse ou en surface. Plus préférentiellement, ce sont des verres silicosodocalciques extra clairs. Le terme extra-clair désigne un verre contenant au plus 0.020% en poids du verre de Fe total exprimé en $Fe_2O_3$ et de préférence au plus 0.015% en poids. Préférentiellement, le verre est un verre trempé, plus préférentiellement le verre est un verre trempé chimiquement. L'avantage lié à l'utilisation d'un verre trempé réside dans le fait que, lors de l'assemblage, celui-ci a moins tendance à se déformer.

Selon un mode de réalisation particulier du mode précédent, la structure selon l'invention est telle que l'ensemble des substrats imperméables sont des substrats verriers.

Selon un mode de réalisation particulier des deux modes précédents, la structure selon l'invention est telle que le ou les substrat(s) verrier(s) est (sont) plan(s) ou incurvé(s). La structure selon l'invention est telle qu'au moins un substrat verrier est recouvert d'une couche conductrice ayant une résistance par carré inférieure ou égale à 15 $\Omega/\square$. Les inventeurs ont déterminé que de manière surprenante une telle couche permet de limiter la dissipation ohmique et permet ainsi d'obtenir des structures comprenant une pluralité de dispositifs organiques électroniques ou optoélectroniques insérés entre les deux substrats dont les propriétés électroniques et/ou optoélectroniques sont uniformes sur la face électroniquement et/ou optoélectroniquement active de la structure. Par les termes « propriétés électroniques et/ou optoélectroniques sont uniformes », on entend désigner que lesdites propriétés ne varient pas de plus de 40 %, préférentiellement de plus de 30%, le plus préférentiellement de plus de 20% d'un point à l'autre d'une face électroniquement et/ou optoélectroniquement active de la structure selon l'invention. Le rôle de cette couche conductrice est de servir d'amenée de courant pour le dispositif électronique ou optoélectronique inséré entre les deux substrats. Lorsque ladite couche conductrice est présente sur un substrat, le film adhésif intercalaire est avantageusement muni de trous de connexion au travers desquelles passent des moyens de connections électriques choisis parmi les rubans adhésifs conducteurs et les colles conductrices, de manière à raccorder électriquement le dispositif organique électronique ou optoélectronique inséré entre les deux substrats à ladite couche conductrice.

Selon un mode de réalisation particulier du mode précédent, la structure selon l'invention est telle que la couche conductrice est choisie parmi un empilement bas émissif à l'argent (simple ou double Ag) ou un revêtement conducteur à base d'oxyde dopé (TCO), préférentiellement sélectionné parmi l'oxyde d'indium dopé à l'étain (ITO), l'oxyde d'étain dopé au fluor, l'oxyde de zinc dopé par au moins un élément dopant sélectionné parmi l'aluminium et le gallium et l'oxyde d'étain dopé par au moins un élément dopant sélectionné parmi le fluor et l'antimoine. Préférentiellement, la couche conductrice est une couche transparente, ladite couche est considérée comme transparente lorsqu'elle présente au sein de la structure selon l'invention, une absorption lumineuse d'au plus 50%, voire d'au plus 30%, préférentiellement d'au plus 20%, plus préférentiellement d'au plus 10%. Par les termes « absorption lumineuse d'au plus 50% », on entend désigner que la couche dans la structure présente une absorption d'au plus 50% du rayonnement visible la traversant, ledit rayonnement étant un rayonnement monochromatique ou polychromatique.

Selon un mode de réalisation alternatif, non conforme à la présente invention, un film conducteur transparent, tel que du polyéthylène téréphtalate (PET) conducteur, est inséré entre le film adhésif intercalaire et le dispositif organique électronique ou optoélectronique. Ledit film transparent conducteur sert d'amenée de courant pour le dispositif électronique ou optoélectronique inséré entre les deux substrats. L'avantage de l'utilisation d'un film conducteur est qu'il permet d'éviter l'utilisation d'un film intercalaire adhésif muni de trous de connexion, les connexions électriques étant directes entre ledit film conducteur, le dispositif organique électronique ou optoélectronique inséré entre les deux substrats et ladite couche conductrice.

Selon un mode de réalisation particulier, la structure selon l'invention est telle que :

$$Y{-}X \geq 0{,}3 \text{ mm}$$

avec X représentant la somme des épaisseurs des supports constituant le(s) dispositif(s) organique(s) électronique(s) ou optoélectronique(s) inséré(s) entre les deux substrats imperméables exprimée en mm et Y représentant l'épaisseur du au moins un film adhésif intercalaire exprimée en mm.

Les inventeurs ont déterminé que de manière surprenante cette relation permet la sélection de film adhésif intercalaire et de dispositif(s) organique(s) électronique(s) ou optoélectronique(s), préférentiellement du ou des dispositif(s) organique(s) électroluminescent(s), apte(s) à être inséré(s) au sein de la structure selon l'invention, ladite structure étant plus particulièrement obtenue par assemblage. Par ailleurs, une telle sélection permet l'obtention de structures présentant un meilleur confinement desdits dispositifs et donc offrant une durée de vie plus longue aux dispositifs ainsi incorporés.

Les supports constituant le(s) dispositif(s) organique(s) électronique(s) ou optoélectronique(s) sont tels qu'au moins un des supports, préférentiellement les deux supports, est(sont) transparent(s). Par les termes « support transparent », on entend désigner un support présentant une absorption lumineuse d'au plus 50%, voire d'au plus 30%, préférentiellement d'au plus 20%, plus préférentiellement d'au plus 10%. Par les termes « absorption lumineuse d'au plus 50% », on entend désigner que le support présente une absorption d'au plus 50% du rayonnement visible le traversant, ledit rayonnement étant un rayonnement monochromatique ou polychromatique. L'un des deux supports est de préférence un support verrier choisi parmi les verres minéraux ou organiques. Les verres minéraux sont préférés. Parmi ceux-ci, on préfère les verres silicosodocalciques clairs ou colorés dans la masse ou en surface. Plus préférentiellement, ce sont des verres silicosodocalciques extra clairs. Le terme extra-clair désigne un verre contenant au plus 0.020% en poids du verre de Fe total exprimé en $Fe_2O_3$ et de préférence au plus 0.015% en poids. Préférentiellement, le verre est un verre trempé, plus préférentiellement le verre est un verre trempé chimiquement. L'avantage lié à l'utilisation d'un verre trempé réside dans le fait que, lors de l'assemblage, celui-ci a moins tendance à se déformer.

Selon un mode particulier de réalisation, la structure selon l'invention est telle que la somme des épaisseurs des supports du ou des dispositif(s) organique(s) électronique(s) ou optoélectronique(s), préférentiellement du ou des dispositif(s) organique(s) électroluminescent(s), est inférieure ou égale à 2,0 mm, préférentiellement inférieure ou égale à 1,1 mm. Les inventeurs ont déterminé que de manière surprenante des épaisseurs de supports inférieures à 2,0 mm, préférentiellement inférieure 1,1 mm, permettent une meilleure insertion desdits dispositifs au sein de la structure, plus particulièrement lorsque ladite structure est obtenue par assemblage.

Préférentiellement, le second support couvercle ou support d'encapsulation a une épaisseur inférieure ou égale à 0,7 mm. Lorsqu'il est en verre, il peut être collé au premier support et à l'empilement de couches organiques à l'aide d'un adhésif dit "pleine face" recouvrant à la fois l'empilement de couches organiques et au moins une portion du premier support, avec une épaisseur suffisante pour éviter l'écrasement des couches organiques lors de l'assemblage. Lorsqu'il est en verre toujours, il peut alternativement présenter un creux pour que ce dernier soit positionné en vis-à-vis des couches organiques de manière à éviter l'écrasement des couches organiques lors de l'assemblage, et adhérer au premier support par un cordon d'adhésif sur son pourtour. De façon alternative, le support couvercle ou support d'encapsulation peut avantageusement être constitué d'une couche d'oxyde métallique, le métal étant sélectionné parmi le groupe consistant en Al, Ti, Sn, Zn et Hf ou de nitrure métallique, le métal étant sélectionné parmi le groupe consistant en Ti, Ta, W et Nb ; préférentiellement la couche est une couche d'oxyde métallique, plus préférentiellement une couche d'oxyde d'aluminium, ladite couche formant un revêtement protecteur contre l'humidité et l'oxygène par exemple et étant obtenue par ALD (de l'anglais Atomic Layer Déposition).

Selon un mode de réalisation préféré, la structure selon l'invention est telle que l'épaisseur du film adhésif intercalaire est supérieure ou égale à 0,4 mm, préférentiellement supérieure ou égale à 0,8 mm. Les inventeurs ont déterminé que de manière surprenante des épaisseurs de film adhésif intercalaire supérieures ou égales à 0,4 mm, préférentiellement supérieures ou égales à 0,8 mm, permettent une meilleure insertion desdits dispositifs au sein de la structure, plus particulièrement lorsque ladite structure est obtenue par assemblage. Avantageusement, le film adhésif intercalaire contenu dans la structure peut résulter de la superposition de deux films intercalaires de même nature insérant le dispositif électronique ou optoélectronique. Le dispositif électronique ou optoélectonique, une oled par exemple, peut être déposé sur un premier film adhésif intercalaire, ledit dispositif étant ensuite recouvert d'un second film intercalaire adhésif préalablement percé d'un trou d'insertion aux dimensions comparables audit dispositif et au sein duquel ledit dispositif est inséré. Ainsi, l'épaisseur du film intercalaire adhésif de la structure selon l'invention peut facilement être adapté de façon à être du même ordre d'épaisseur que le dispositif électronique ou optoélectronique.

Selon une mise en oeuvre avantageuse, le procédé de fabrication par assemblage d'une structure comprenant un dispositif organique électronique ou optoélectronique, préférentiellement un dispositif organique électroluminescent, selon l'invention est tel qu'il comprend les étapes successives suivantes :

a) pose sur un premier substrat, préférentiellement verrier, d'un premier film adhésif intercalaire,

b) pose d'au moins un dispositif organique électronique ou optoélectronique, préférentiellement d'au moins un dispositif organique électronique ou optoélectronique, préférentiellement d'au moins un dispositif organique électroluminescent,

c) mise en place des connections électriques, préférentiellement sous forme d'un film conducteur transparent, tel que du PET conducteur, et/ou de rubans adhésifs conducteurs,

d) pose d'un second film adhésif intercalaire, préférentiellement de même nature que le premier,

e) pose d'un second substrat, préférentiellement verrier,

f) solidarisation de la structure obtenue par installation de moyens de fixation amovibles entre le premier et le second substrat, préférentiellement lesdits moyens ne nécessitant pas de modifications structurelles des substrats et permettant les échanges gazeux,

g) la structure obtenue étant ensuite placée dans une enceinte pour être soumise à un cycle d'assemblage comprenant les étapes successives suivantes:

g 1. dégazage de l'assemblage obtenu par application d'un vide d'au moins 0,15 bar, préférentiellement d'au moins 0,35 bar, durant au moins 30 minutes, préférentiellement durant au moins 45 minutes,

g 2. élévation de la température de l'enceinte sous un vide d'au moins 0,15 bar, préférentiellement d'au moins 0,35 bar, préférentiellement durant au moins 45 minutes, jusqu'à atteindre une température d'au plus 120°C , préférentiellement d'au plus 95°C,

g 3. arrêt de la mise sous vide et élévation ou maintien de la température de l'enceinte durant au moins 15 minutes, jusqu'à atteindre une température d'au plus 120°C, préférentiellement d'au plus 110°C,

g 4. maintien de l'enceinte à une température d'au plus 120°C, préférentiellement d'au plus 110°C, durant au moins 90 minutes, préférentiellement durant au moins 150 minutes, plus préférentiellement durant au moins 180 minutes,

g 5. diminution de la température de l'enceinte jusqu'à une température d'au plus 80°C,

g 6. ouverture de l'enceinte.

Par le terme « enceinte », on entend désigner un autoclave ou tout récipient adapté à recevoir une structure devant être soumise à un cycle d'assemblage tel que défini.

Selon une mise en oeuvre avantageuse du mode de mise en oeuvre précédent, le procédé de fabrication par assemblage d'une structure comprenant un dispositif organique électronique ou optoélectronique, préférentiellement un dispositif organique électroluminescent, est tel que lors de l'étape g la structure obtenue est placée dans une première enceinte ou récipient, avantageusement choisi parmi les récipients déformables par mise sous vide tel que les sacs en toile hermétique ou en plastique, pour être soumise à un cycle d'assemblage comprenant les étapes successives suivantes:

g 1. dégazage de la structure obtenue par application d'un vide d'au moins 0,15 bar dans le récipient, préférentiellement d'au moins 0,35 bar, durant au moins 30 minutes, préférentiellement durant au moins 45 minutes,

g 2. arrêt de la mise sous vide et fermeture du récipient, le vide étant d'au moins 0,15 bar dans le récipient, préférentiellement d'au moins 0,35 bar,

g 3. le récipient est ensuite placé dans une seconde enceinte ou enceinte chauffante tel qu'un autoclave,

g 4. élévation de la température de la seconde enceinte, préférentiellement durant au moins 45 minutes, jusqu'à atteindre une température d'au plus 120°C, préférentiellement d'au plus 95°C. Avantageusement, la seconde enceinte est placée à une pression d'au plus 11 bars, préférentiellement d'au plus 4 bars, plus préférentiellement d'au plus 3 bars, le plus préférentiellement d'au plus 2 bar, la pression exercée sur la première enceinte permettant de réduire le nombre de bulles de gaz dans la structure,

g 5. élévation ou maintien de la température de la seconde enceinte durant au moins 15 minutes, jusqu'à atteindre une température d'au plus 120°C, préférentiellement d'au plus 110°C,

g 6. maintien de la seconde enceinte à une température d'au plus 120°C, préférentiellement d'au plus 110°C, durant au moins 90 minutes, préférentiellement durant au moins 150 minutes, plus préférentiellement durant au moins 180 minutes,

g 7. diminution de la température de la seconde enceinte jusqu'à une température d'au plus 80°C,

g 8. ouverture de la seconde enceinte et récupération du récipient,

g 9. ouverture du récipient.

L'avantage offert par l'utilisation de récipients déformables par mise sous vide tel que les sacs en toile hermétique ou en plastique, tel que par exemple des sacs en silicone, est qu'ils permettent par le vide créé de solidariser la structure obtenue avant son traitement thermique.

Selon une mise en oeuvre avantageuse, le procédé de fabrication par assemblage d'une structure comprenant un dispositif organique électronique ou optoélectronique, préférentiellement un dispositif organique électroluminescent, est tel que lors de l'étape g, la structure obtenue est placée dans une enceinte pour être soumise à un cycle d'assemblage comprenant les étapes successives suivantes:

g 1. dégazage de l'assemblage obtenu par application d'un vide d'au moins 0,35 bar, durant au moins 30 minutes, préférentiellement durant au moins 45 minutes,

g 2. élévation de la température de l'enceinte sous un vide dans l'enceinte d'au moins 0,35 bar, durant au moins 45 minutes, jusqu'à atteindre une température d'au plus 95°C,

g 3. arrêt de la mise sous vide et élévation de la température de l'enceinte durant au moins 15 minutes, jusqu'à atteindre une température d'au plus 120°C, préférentiellement d'au plus 110°C,

g 4. maintien de l'enceinte à une température d'au plus 120°C, préférentiellement au plus 110°C, durant au moins 150 minutes, préférentiellement durant au moins 180 minutes,

g 5. diminution de la température de l'enceinte jusqu'à une température d'au plus 80°C,

g 6. ouverture de l'enceinte.

Selon une mise en oeuvre particulière, le procédé de fabrication par assemblage d'une structure comprenant un dispositif organique électronique ou optoélectronique, préférentiellement un dispositif organique électroluminescent selon l'invention, est tel que l'étape a) comprend l'utilisation d'un substrat recouvert d'un revêtement conducteur et d'un film adhésif intercalaire pourvu de trous de connexion, et qu'une étape supplémentaire de mise en place de connections électriques b') est introduite entre les étapes a) et b), lesdites connections électriques de l'étape b') étant réalisées au travers des trous de connexion du film adhésif de l'étape a). L'avantage de cette variante est d'éviter l'utilisation d'un film conducteur transparent.

Selon une mise en oeuvre préférée, le procédé est tel que les moyens de fixation de l'étape f) sont choisis parmi les pinces et les rubans adhésifs poreux. Préférentiellement les moyens de fixation sont des rubans adhésifs poreux. L'utilisation de rubans adhésif poreux est plus particulièrement préférée lors de l'utilisation de récipients déformables par mise sous vide tel que les sacs en toile hermétique ou en plastique, tel que par exemple des sacs en silicone ; lesdits rubans permettant d'éviter une possible déchirure desdits récipients déformables.

Selon une mise en oeuvre particulière des deux modes précédents, le procédé est tel que les moyens de connections électriques sont choisis parmi les rubans adhésifs conducteurs et les colles conductrices.

Les trous réalisés dans le film intercalaire pour assurer la connexion électrique ou l'insertion du dispositif électronique ou optoélectronique sont avantageusement réalisés par laser afin d'obtenir un meilleur contrôle de la découpe. Dans le cas des trous permettant la mise en place des connexions électriques, ces derniers sont de préférence de forme cylindrique et présentent de préférence un diamètre de l'ordre de 1,0 mm.

Selon une mise en oeuvre alternative au mode précédent, non conforme à la présente invention, le procédé de fabrication par assemblage d'une structure comprenant un dispositif organique électronique ou optoélectronique, préférentiellement un dispositif organique électroluminescent, est tel qu'il comprend les étapes successives suivantes :

a) dépôt d'au moins dispositif organique électronique ou optoélectronique, préférentiellement d'au moins un dispositif organique électroluminescent, directement sur un premier substrat, préférentiellement verrier, recouvert d'une couche conductrice,
b) mise en place des connections électriques, préférentiellement sous forme fils soudés entre le dispositif organique électroluminescent et la couche conductrice,
c) dépôt d'un premier film adhésif intercalaire,
d) dépôt d'un second substrat, préférentiellement verrier,
e) solidarisation de la structure obtenue par installation de moyens de fixation amovibles entre le premier et le second substrat, lesdits moyens ne nécessitant pas de modifications structurelles des substrats et permettant les échanges gazeux,
f) la structure obtenue est ensuite placée dans une enceinte pour être soumise à un cycle d'assemblage comprenant les étapes successives suivantes:

f1. dégazage de l'assemblage obtenu par application d'un vide d'au moins 0,15 bar, préférentiellement d'au moins 0,35 bar, durant au moins 30 minutes, préférentiellement durant au moins 45 minutes,
f2. élévation de la température de l'enceinte sous un vide d'au moins 0,15 Bar, préférentiellement d'au moins 0,35 bar, préférentiellement durant au moins 60 minutes, plus préférentiellement durant au moins 45 minutes, jusqu'à atteindre une température d'au plus 120°C, préférentiellement d'au plus 95°C,
f3. arrêt de la mise sous vide, préférentiellement durant au moins 15 minutes, jusqu'à atteindre une température d'au plus 120 °C, préférentiellement d'au plus 110°C,
f4. maintien de l'enceinte à une température d'au plus 120°C, préférentiellement d'au plus 110°C, durant au moins 90 minutes, préférentiellement durant au moins 120 minutes, plus préférentiellement durant au moins 150 minutes, le plus préférentiellement durant au moins 180 minutes,
f5. diminution de la température de l'enceinte jusqu'à une température d'au plus 80°C,
f6. ouverture de l'enceinte.

Par le terme « enceinte », on entend désigner un autoclave ou un récipient.

Selon une mise en oeuvre préférée du mode de mise en oeuvre précédent, le procédé de fabrication par assemblage d'une structure comprenant un dispositif organique électronique ou optoélectronique, préférentiellement un dispositif organique électroluminescent, est tel que lors de l'étape f, la structure obtenue est placée dans une première enceinte ou récipient, avantageusement choisi parmi les récipient déformables par mise sous vide tel que les sacs en toile hermétique ou en plastique, pour être soumise à un cycle d'assemblage comprenant les étapes successives suivantes:

f1. dégazage de l'assemblage obtenu par application d'un vide d'au moins 0,15 bar dans le récipient, préférentiellement d'au moins 0,35 bar, durant au moins 30 minutes, préférentiellement durant au moins 45 minutes,
f2. arrêt de la mise sous vide et fermeture du récipient, le vide étant d'au moins 0,15 bar dans le récipient, préférentiellement d'au moins 0,35 bar,
f3. le récipient est ensuite placé dans une seconde enceinte ou enceinte chauffante tel qu'un autoclave,
f4. élévation de la température de la seconde enceinte préférentiellement durant au moins 60 minutes, plus préférentiellement durant au moins 45 minutes, jusqu'à atteindre une température d'au plus 120°C, préférentiellement d'au plus 95°C. Avantageusement, la seconde enceinte est placée sous une pression d'au plus 11 bars, préférentiellement d'au plus 4 bars, plus préférentiellement d'au plus 3 bars, le plus préférentiellement d'au plus 2 bars, la pression exercée sur la première enceinte permettant de réduire le nombre de bulles de gaz dans la structure,

f5. élévation ou maintien de la température, préférentiellement durant au moins 15 minutes, jusqu'à atteindre une température d'au plus 120 °C, préférentiellement d'au plus 110°C,

f6. maintien de l'enceinte à une température d'au plus 120°C, préférentiellement d'au plus 110°C, durant au moins 90 minutes, préférentiellement durant au moins 120 minutes, plus préférentiellement durant au moins 150 minutes, le plus préférentiellement durant au moins 180 minutes,

f7. diminution de la température de l'enceinte jusqu'à une température d'au plus 80°C,

f8. ouverture de l'enceinte.

L'avantage offert par l'utilisation de récipients déformables par mise sous vide tel que les sacs en toile hermétique ou en plastique, tel que par exemple des sacs en silicone, est qu'ils permettent par le vide créé de solidariser la structure obtenue avant son traitement thermique.

Selon une mise en oeuvre préférée de la mise en oeuvre précédente, le procédé de fabrication par assemblage d'une structure comprenant un dispositif organique électronique ou optoélectronique, préférentiellement un dispositif organique électroluminescent, est tel que lors de que lors de l'étape f la structure obtenue est placée dans une enceinte pour être soumise à un cycle d'assemblage comprenant les étapes successives suivantes:

f1. dégazage de l'assemblage obtenu par application d'un vide dans l'enceinte d'au moins 0,35 bar, durant au moins 45 minutes,

f2. élévation de la température de l'enceinte sous un vide d'au moins 0,35 bar, préférentiellement durant au moins 60 minutes, plus préférentiellement durant au moins 45 minutes, jusqu'à atteindre une température d'au plus 95°C,

f3. arrêt de la mise sous vide, préférentiellement durant au moins 15 minutes, jusqu'à atteindre une température d'au plus 110°C,

f4. maintien de l'enceinte à une température d'au plus 120°C, préférentiellement d'au plus 110°C, durant au moins 90 minutes, préférentiellement durant au moins 120 minutes, plus préférentiellement durant au moins 150 minutes, le plus préférentiellement durant au moins 180 minutes,

f5. diminution de la température de l'enceinte jusqu'à une température d'au plus 80°C,

f6. ouverture de l'enceinte.

Selon une mise en oeuvre préférée, le procédé est tel que les moyens de fixation de l'étape e) sont choisis parmi les pinces et les rubans adhésifs poreux.

L'invention concerne également les utilisations de la structure selon l'invention telle que par exemple les écrans tactiles, les sources de lumière sous toute forme, les écrans d'affichage d'information.

Lors d'une utilisation comme écran tactile basé sur une fonction tactile capacitive, la contribution capacitive est avantageusement gravée par laser directement sur la couche conductrice. La gravure laser peut être située juste en dessous du premier support de l'oled, ladite gravure étant préférentiellement de même dimension que le dispositif optoélectronique, préférentiellement que l'OLED.

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :

• la figure 1 présente une structure, non conforme à la présente invention, comprenant deux substrats en verre clair (1, 2), un dispositif OLED (3), un film adhésif intercalaire (4) en EVA, des moyens de connexion électrique (5) et un ruban adhésif (6),

• la figure 2 illustre une structure selon l'invention comprenant deux substrats en verre clair (1, 2), un dispositif OLED (3), un film adhésif intercalaire (4) en EVA, des moyens de connexion électrique (5) via une couche conductrice déposée sur un des substrats verriers et un ruban adhésif (6),

• la figure 3 montre un cycle typique d'autoclave auquel la structure selon l'invention est soumise lors de son assemblage.

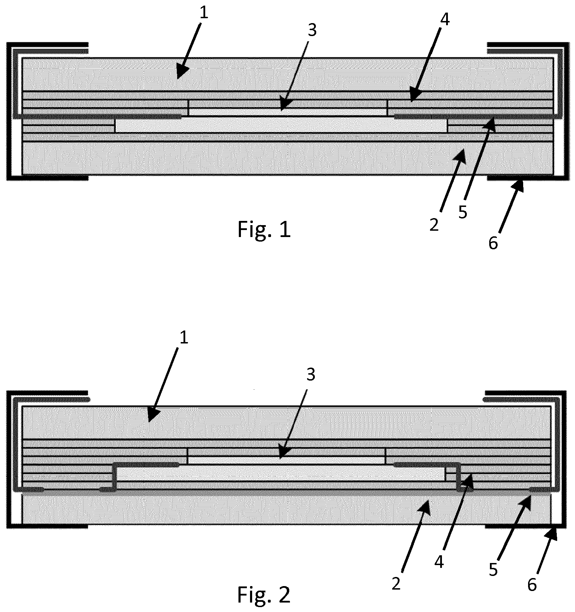

On présente, en relation avec la figure 1, un mode de réalisation 2. d'une structure non conforme à la présente invention comprenant deux substrats en verre clair (1, 2), un dispositif OLED (3), un film adhésif intercalaire (4) en EVA, des moyens de connexion électrique (5) et de rubans adhésifs (6). Les moyens de connexion électrique étant un film transparent conducteur en PET, ledit film étant en contact électrique avec le dispositif par l'intermédiaire des rubans adhésifs conducteurs. Les moyens de connexion électrique peuvent également être réduits aux seuls rubans adhésifs conducteurs. Les rubans adhésifs conducteurs assurent l'alimentation électrique de la structure selon l'invention.

La figure 2 illustre une structure selon l'invention comprenant deux substrats en verre clair (1, 2), un dispositif OLED (3), un film adhésif intercalaire (4) en EVA, des moyens de connexion électrique (5) via une couche conductrice déposée sur un des substrats verriers et un ruban adhésif (6), ladite couche étant gravée. Les moyens de connexion électrique étant une couche conductrice recouvrant un substrat en verre clair et une colle conductrice insérée au travers des trous de connexion réalisés dans le film intercalaire adhésif, la dite couche étant en contact électrique avec des rubans adhésifs conducteurs assurant l'alimentation électrique de la structure selon l'invention. Lorsque la colle conductrice est utilisée comme moyen de connexion électrique, le substrat comportant la couche conductrice est recouvert du film intercalaire adhésif et c'est sur ce dernier qu'est déposé l'oled. Alternativement à la colle conductrice, on peut utiliser comme moyens de connexion électrique entre l'oled et la couche conductrice des fils, lesdits fils étant soudés à l'oled et à la couche conductrice. Lorsque des fils sont utilisés comme moyen de connexion électrique entre la couche conductrice et l'oled, l'oled est déposée directement sur le substrat porteur de la couche conductrice, le film intercalaire adhésif n'est de ce fait pas déposé directement sur le substrat porteur de la couche conductrice mais au-dessus dudit substrat préalablement pourvu de l'oled.

Bien entendu, l'invention n'est pas limitée aux exemples de réalisation mentionnés ci-dessus.

Le procédé de fabrication par assemblage d'une structure comprenant un dispositif organique électronique ou optoélectronique, préférentiellement un dispositif organique électroluminescent, utilisé dans ce premier exemple est tel qu'il comprend les étapes successives suivantes :

    a) dépôt sur un premier substrat verrier d'un film adhésif intercalaire,

    Le film adhésif intercalaire est choisi en EVA car, par rapport au PVB :

- ce dernier nécessite des températures en autoclave inférieures (110°C pour l'EVA contre 125°C pour le PVB),
- il ne nécessite qu'un seul cycle de température, le PVB ayant besoin de 2 cycles (pré-encollage et le collage) pour obtenir le produit final,
- il nécessite l'utilisation d'une plus faible pression dans l'autoclave, au moins 11 bars comparés à au moins 15 bars pour le PVB,
- il ne nécessite pas de contrôler l'humidité et la température lors du procédé de fabrication du feuilleté contrairement au PVB,
- L'EVA nécessite l'utilisation de pressions (positive et négative de l'ordre de 4,0 bars et 0, 15 bar) en autoclave, inférieures aux pressions utilisées pour le PVB, lesdites pressions si elles sont élevées pouvant endommager l'oled.

    b) pose d'un dispositif organique électroluminescent,

    c) mise en place des connections électriques,

    d) dépôt d'un second film adhésif intercalaire de même nature que le premier,

    e) dépôt d'un second substrat verrier,

    f) solidarisation de la structure obtenue par installation de moyens de fixation amovibles entre le premier et le second substrat. La solidarisation de la structure est réalisée par application de rubans adhésifs sur les bords de la structure assemblée, lesdits ruban étant apte à maintenir la structure à une température de 110 ° C, l'EVA étant fluide à cette température. Les rubans adhésifs sont appliqués à chaque coin de la structure. En outre, les rubans adhésifs sont pourvus de trous de manière à assurer un dégazage de la structure lors du procédé d'assemblage.

    g) la structure obtenue est ensuite placée dans une enceinte chauffante ou autoclave pour être soumise à un cycle d'assemblage comprenant les étapes successives suivantes :

    g 1. dégazage de la structure obtenu par application d'un vide d'au moins 0,35 bar dans l'enceinte, durant au moins 45 minutes. Afin d'assurer le dégazage de la structure et d'éviter la formation de bulles d'air dans l'EVA, celle-ci est préalablement enfermée dans un sac, préférentiellement en silicone, dans lequel on fait le vide. Le vide ainsi réalisée est suffisant pour maintenir la structure en place dans le sac sous vide d'une part et de permettre d'autre part le dégazage de la structure dans ledit sac. La phase de dégazage est la première étape avant le chauffage de l'autoclave. Cette étape dure 45 minutes,

    g 2. élévation de la température de l'enceinte sous un vide d'au moins 0,35 Bar, durant au moins 45 minutes, jusqu'à atteindre une température d'au plus 95°C,

    g 3. élévation de la température de l'enceinte durant au moins 45 minutes, jusqu'à atteindre une température d'au plus 110°C, ladite enceinte n'étant plus maintenue sous vide. Le dégazage sous vide est arrêté par remise à l'air de l'enceinte,

    g 4. maintien de l'enceinte à une température d'au plus 120°C durant au moins 180 minutes. La température au sein de l'enceinte est maintenue à 110 ° C, pendant au moins 150 minutes,

    g 5. diminution de la température de l'enceinte jusqu'à une température d'au plus 80°C. La température au sein de l'enceinte est amenée à 80°C et ce durant un lapse de temps de 15 minutes,

    g 6. ouverture de l'enceinte. On n'attend pas que la température de structure atteigne la température ambiante, les inventeurs ayant déterminé que de manière surprenante de l'EVA nécessite une brusque diminution de température afin que la structure présente un maximum de transparence.

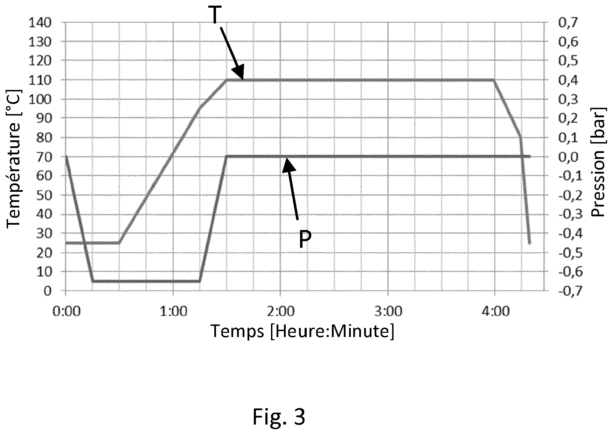

La figure 3 présente un cycle d'autoclave illustrant l'étape g du procédé.

Le procédé de fabrication par assemblage d'une structure comprenant un dispositif organique électroluminescent, utilisé dans un second exemple est tel que lors de l'étape g, la structure obtenue est placée dans un sac en toile hermétique ou en plastique, tel qu'un sac en silicone ou un sac réalisé à l'aide des films Vacfilm 450V ou Vacfilm 800G commercialisés par la firme AEROVAC, lesdits films étant scellés afin de réaliser ledit sac à l'aide d'un ruban colle à base de polybutylène, tel que le « LTS90B Sealant Tape » commercialisé par la firme AEROVAC, pour être soumise à un cycle d'assemblage comprenant les étapes successives suivantes:

g 1. dégazage de la structure obtenue par application d'un vide d'au moins 0,35 bar dans le récipient, durant au moins 45 minutes,

g 2. arrêt de la mise sous vide et fermeture du sac, le vide étant d'au moins 0,35 bar dans le récipient,

g 3. le sac est ensuite placé dans une enceinte chauffante ou autoclave,

g 4. élévation de la température de l'enceinte chauffante ou autoclave, durant au moins 45 minutes, jusqu'à atteindre une température d'au plus 95°C. L'autoclave est mis à une pression d'au plus 2 bars, la pression exercée sur le sac permettant de réduire le nombre de bulles de gaz dans la structure,

g 5. élévation de la température de l'enceinte chauffante ou autoclave durant au moins 15 minutes, jusqu'à atteindre une température d'au plus 110°C,

g 6. maintien de l'enceinte chauffante ou autoclave à une température d'au plus 110°C durant au moins 180 minutes,

g 7. diminution de la température de la seconde enceinte jusqu'à une température d'au plus 80°C,

g 8. ouverture de l'enceinte chauffante ou autoclave et récupération du sac,

g 9. ouverture du sac. Dans un troisième exemple, non conforme à la présente invention, un procédé de fabrication par assemblage d'une structure comprenant un dispositif organique électroluminescent comprend les étapes successives suivantes :

a) pose d'un dispositif organique électroluminescent, directement sur un premier substrat verrier recouvert d'une couche conductrice,

b) mise en place des connections électriques sous forme fils soudés entre le dispositif organique électroluminescent et la couche conductrice,

c) pose d'un premier film adhésif intercalaire,

d) pose d'un second substrat verrier,

e) solidarisation de la structure obtenue par installation de moyens de fixation amovibles entre le premier et le second substrat,

f) la structure obtenue est ensuite placée dans une enceinte pour être soumise à un cycle d'assemblage comprenant les étapes successives suivantes:

f1. dégazage de l'assemblage obtenu par application d'un vide d'au moins 0,35 bar, durant au moins 45 minutes,

f2. élévation de la température de l'enceinte sous un vide d'au moins 0,35 bar, durant au moins 45 minutes, jusqu'à atteindre une température d'au plus 95°C,

f3. arrêt de la mise sous vide, durant au moins 15 minutes, jusqu'à atteindre une température d'au plus 110°C,

f4. maintien de l'enceinte à une température d'au plus 110°C, durant au moins 180 minutes,

f5. diminution de la température de l'enceinte jusqu'à une température d'au plus 80°C,

f6. ouverture de l'enceinte.

Dans l'exemple suivant, le procédé de fabrication par assemblage d'une structure comprenant un dispositif organique électroluminescent, est tel que lors de que lors de l'étape f, la structure obtenue est placée un sac en toile hermétique ou en plastique ou un sac réalisé à l'aide des films Vacfilm 450V ou Vacfilm 800G commercialisés par la firme AEROVAC, lesdits films étant scellés afin de réaliser ledit sac à l'aide d'un ruban colle à base de polybutylène, tel que le « LTS90B Sealant Tape » commercialisé par la firme AEROVAC, pour être soumise à un cycle d'assemblage comprenant les étapes successives suivantes:

f1. dégazage de l'assemblage obtenu par application d'un vide d'au moins 0,35 bar, durant au moins 45 minutes,

f2. arrêt de la mise sous vide et fermeture du sac, le vide étant d'au moins 0,35 bar dans le sac,

f3. le récipient est ensuite placé dans une enceinte chauffante ou autoclave,

f4. élévation de la température de l'enceinte chauffante ou autoclave durant au moins 45 minutes, jusqu'à atteindre une température d'au plus 95°C. L'autoclave est mis à une pression d'au plus 2 bars,

f5. élévation de la température, durant au moins 15 minutes, jusqu'à atteindre une température d'au plus 110°C,

f6. maintien de l'enceinte chauffante ou autoclave à une température d'au plus 110°C, durant au moins 180 minutes,

f7. diminution de la température de l'enceinte chauffante ou autoclave jusqu'à une température d'au plus 80°C,

f8. ouverture de l'enceinte chauffante ou autoclave et récupération du sac,

f9. ouverture du sac.

## Revendications

1. Structure comprenant au moins deux substrats imperméables (1, 2), au moins un de ces substrats étant transparent, au moins un de ces substrats étant un substrat verrier recouvert d'une couche conductrice ayant une résistance par carré inférieure ou égale à 15 $\Omega/\square$, au moins un film adhésif intercalaire (4) résultant de la superposition de deux films intercalaires de même nature et au moins un dispositif organique électronique ou optoélectronique (3) entre les deux substrats, ledit dispositif étant inséré entre les deux films intercalaires, ledit dispositif étant raccordé électriquement à ladite couche conductrice, ledit dispositif comprenant un empilement de couches organiques comprenant une couche photoélectroactive avec de part et d'autre de celle-ci, des couches organiques additionnelles qui facilitent le transport des charges parmi ces couches citons une couche de transport de trous et une couche transportant des électrons, ledit dispositif comprenant un empilement de couches organiques semiconductrices inséré entre deux supports permettant l'émission de lumière, la génération de charges électriques et/ou le transport de charges électriques, ledit empilement de couches organiques contenant exclusivement des matériaux dont la température de transition vitreuse (TgM) est telle que

$$\mathrm{Tg_M - Tg_f \geq 150\ ^\circ C}$$

avec Tgf : température de transition vitreuse du matériau constituant le film adhésif intercalaire.

2. Structure selon la revendication 1, telle que le film adhésif intercalaire comprend au moins une couche de matières plastiques choisies parmi un polyvinylbutyral, un polyuréthane, un polycarbonate, un poly(méthacrylate de méthyle), un polypropylène, un copolymère éthylène/acétate de vinyle, un copolymère cyclooléfinique, un polyéthylène, un polyester thermoplastique, une résine acrylique, un copolymère chlorure de vinyle/méthacrylate de glycidyl.

3. Structure selon une quelconque des revendications précédentes, telle qu'elle est une structure laminée dont les matériaux constituant l'empilement de couches organiques ont une température de transition vitreuse ($Tg_M$) supérieure ou égale à la température maximum requise lors du procédé d'assemblage ($T_a$).

4. Structure selon une quelconque des revendications précédentes telle que les deux substrats imperméables sont des substrats verriers.

5. Structure selon une quelconque des revendications précédentes telle que le ou les substrat(s) verrier(s) est (sont) plan(s) ou incurvé(s).

6. Structure selon l'une quelconque des revendications précédentes, telle que la couche conductrice est choisie parmi un empilement bas émissif à l'argent (simple ou double Ag) ou un revêtement conducteur à base d'oxyde dopé (TCO), préférentiellement sélectionné parmi l'oxyde d'indium dopé à l'étain (ITO), l'oxyde de zinc dopé par au moins un élément dopant sélectionné parmi l'aluminium, le gallium ou l'oxyde d'étain dopé au fluor ou à l'antimoine.

7. Structure selon une quelconque des revendications précédentes, telle que :

$$\mathrm{Y - X \geq 0{,}3\ mm}$$

avec X représentant la somme des épaisseurs des supports du dispositif organique électroluminescent exprimée en mm et Y représentant l'épaisseur du film adhésif intercalaire exprimée en mm.

8. Structure selon une quelconque des revendication précédentes telle que la somme des épaisseurs des supports du dispositif organique électroluminescent est inférieure ou égale à 2,0 mm, préférentiellement inférieure ou égale à 1,1 mm.

9. Structure selon une quelconque des revendications précédentes, telle que l'épaisseur du film adhésif intercalaire est supérieure ou égale à 0,4 mm, préférentiellement supérieure ou égale à 0,8 mm.

## Patentansprüche

1. Struktur, umfassend mindestens zwei undurchlässige Substrate (1, 2), wobei mindestens eines dieser Substrate transparent ist, wobei mindestens eines dieser Substrate ein Glassubstrat ist, das mit einer leitenden Schicht bedeckt ist, die einen Flächenwiderstand kleiner oder gleich 15 $\Omega/\alpha$ aufweist, mindestens einen Zwischenschicht-Klebefilm (4), der aus der Schichtung von zwei Zwischenschicht-Filmen gleicher Beschaffenheit übereinander resultiert, und mindestens eine organische elektronische oder optoelektronische Vorrichtung (3) zwischen den beiden Substraten, wobei die Vorrichtung zwischen den beiden Zwischenschicht-Filmen eingefügt ist, wobei die Vorrichtung elektrisch an die leitende Schicht angeschlossen ist, wobei die Vorrichtung einen Stapel von organischen Schichten umfasst, der eine photoelektrisch aktive Schicht umfasst, wobei auf jeder Seite der photoelektrisch aktiven Schicht zusätzliche organische Schichten vorhanden sind, die den Transport von Ladungen zwischen diesen Schichten erleichtern, wobei eine Lochtransportschicht und eine Schicht, die Elektronen transportiert, zu nennen sind, wobei die Vorrichtung einen Stapel von organischen Halbleiterschichten umfasst, die zwischen zwei Träger eingefügt sind, die die Lichtemission, die Erzeugung von elektrischen Ladungen und/oder den Transport von elektrischen Ladungen ermöglichen, wobei der Stapel aus organischen Schichten ausschließlich Materialien enthält, deren Glasübergangstemperatur ($Tg_M$) so ist, dass

$$Tg_M - Tg_f \geq 150\ °C$$

wobei $Tg_f$: Glasübergangstemperatur des Materials, das den Zwischenschicht-Klebefilm bildet.

2. Struktur nach Anspruch 1, wobei der Zwischenschicht-Klebefilm mindestens eine Kunststoffschicht umfasst, ausgewählt aus einem Polyvinylbutyral, einem Polyurethan, einem Polycarbonat, einem Poly(methylmethacrylat), einem Polypropylen, einem Ethylen/Vinylacetat-Copolymer, einem cycloolefinischen Copolymer, einem Polyethylen, einem thermoplastischen Polyester, einem Acrylharz und einem Vinylchlorid/Glycidylmethacrylat-Copolymer.

3. Struktur nach einem der vorhergehenden Ansprüche, wobei die Struktur eine laminierte Struktur ist, deren aus dem Stapel organischer Schichten bestehenden Materialien eine Glasübergangstemperatur (TgM) größer oder gleich einer maximalen Temperatur aufweisen, die während eines Montageprozesses (Ta) erforderlich ist.

4. Struktur nach einem der vorhergehenden Ansprüche, wobei die zwei undurchlässigen Substrate Glassubstrate sind.

5. Struktur nach einem der vorhergehenden Ansprüche, wobei das Glassubstrat (die Glassubstrate) flach oder gekrümmt ist (sind).

6. Struktur nach einem der vorhergehenden Ansprüche, wobei die leitende Schicht ausgewählt ist aus einem Stapel mit geringem Emissionsvermögen aus Silber (Einfach- oder Doppel-Ag) oder einer leitenden Beschichtung basierend auf dotiertem Oxid (TCO), vorzugsweise ausgewählt aus zinndotiertem Indiumoxid (ITO), Zinkoxid, das mit mindestens einem dotierenden Element dotiert ist, ausgewählt aus Aluminium, Gallium, oder fluor- oder antimondotiertem Zinnoxid.

7. Struktur nach einem der vorhergehenden Ansprüche, wobei:

$$Y\text{-}X \geq 0,3\ mm$$

wobei X für die Summe der Dicken der Träger der organischen Elektrolumineszenzvorrichtung steht, ausgedrückt in mm, und Y für die Dicke des Zwischenschicht-Klebefilms steht, ausgedrückt in mm.

8. Struktur nach einem der vorhergehenden Ansprüche, wobei die Summe der Dicken der Träger der organischen Elektrolumineszenzvorrichtung kleiner oder gleich 2,0 mm, vorzugsweise kleiner oder gleich 1,1 mm ist.

9. Struktur nach einem der vorhergehenden Ansprüche, wobei die Dicke des Zwischenschicht-Klebefilms größer oder gleich 0,4 mm, vorzugsweise größer oder gleich 0,8 mm ist.

## Claims

1. Structure comprising at least two impermeable substrates (1, 2), at least one of these substrates being transparent, at least one of these substrates being a glass substrate coated with a conducting layer having a resistance per square of less than or equal to 15 $\Omega/\square$, at least one interposed adhesive film (4) resulting from the superimposition of two interposed films of the same nature and at least one organic electronic or optoelectronic device (3) between the two substrates, said device being inserted between the two interposed films, said device being electrically connected to said conducting layer, said device comprising a stack of organic layers comprising a photoelectroactive layer with, on either side of the latter, additional organic layers which facilitate the transport of charges (mention may be made, among these layers, of a hole transport layer and an electron transport layer), said device comprising a stack of organic semiconducting layers, inserted between two supports, which makes possible the emission of light, the generation of electric charges and/or the transport of electric charges, said stack of organic layers containing exclusively materials for which the glass transition temperature ($Tg_M$) is such that:

$$Tg_M - Tg_f \geq 150°C$$

with $Tg_f$: glass transition temperature of the material constituting the interposed adhesive film.

2. Structure according to Claim 1, such that the interposed adhesive film comprises at least one layer of plastics chosen from a polyvinyl butyral, a polyurethane, a polycarbonate, a poly(methyl methacrylate), a polypropylene, an ethylene/vinyl acetate copolymer, a cycloolefinic copolymer, a polyethylene, a thermoplastic polyester, an acrylic resin or a vinyl chloride/glycidyl methacrylate copolymer.

3. Structure according to either one of the preceding claims, such that it is a laminated structure, the materials of which constituting the stack of organic layers have a glass transition temperature (TgM) which is greater than or equal to the maximum temperature required during the assembling process (Ta).

4. Structure according to any one of the preceding claims, such that the two impermeable substrates are glass substrates.

5. Structure according to any one of the preceding claims, such that the glass substrate(s) is (are) flat or curved.

6. Structure according to any one of the preceding claims, such that the conducting layer is chosen from a silver (single or double Ag) low-e stack or a conductive coating based on doped oxide (TCO), preferably selected from tin-doped indium oxide (ITO), zinc oxide doped with at least one doping element selected from aluminium and gallium, and tin oxide doped with fluorine or with antimony.

7. Structure according to any one of the preceding claims, such that:

$$Y-X \geq 0.3 \text{ mm}$$

with X representing the sum of the thicknesses of the supports of the organic light-emitting device, expressed in mm, and Y representing the thickness of the interposed adhesive film, expressed in mm.

8. Structure according to any one of the preceding claims, such that the sum of the thicknesses of the supports of the organic light-emitting device is less than or equal to 2.0 mm, preferably less than or equal to 1.1 mm.

9. Structure according to any one of the preceding claims, such that the thickness of the interposed adhesive film is greater than or equal to 0.4 mm, preferably greater than or equal to 0.8 mm.

Fig. 1

Fig. 2

Fig. 3

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- BR MU8802233 U2
- JP 08236271 B
- JP 2006228519 B
- US 20100148665 A
- WO 2008012460 A